# FASCICULE DE BREVET EUROPEEN

(11) **EP 2 497 128 B1**
(45) Date de publication et mention de la délivrance du brevet: **02.04.2014**
(21) Numéro de dépôt: 10788364.7
(22) Date de dépôt: 29.10.2010
(51) Int. Cl.: H01L 37/02

(54) **PROCEDE DE CONVERSION D'ENERGIE THERMIQUE EN ENERGIE ELECTRIQUE UTILISANT UNE SUSPENSION COLLOÏDALE DE NANOPARTICULES PYROELECTRIQUES, DISPOSITIF POUR SA MISE EN OEUVRE ET SUSPENSION COLLOIDALE UTILISEE**
VERFAHREN ZUR UMWANDLUNG VON WÄRME- IN ELEKTRISCHE ENERGIE ANHAND EINER KOLLOIDALEN SUSPENSION AUS PYROELEKTRISCHEN NANOPARTIKELN, VORRICHTUNG ZUR UMSETZUNG DIESES VERFAHRENS UND KOLLOIDALE SUSPENSION
METHOD FOR CONVERTING THERMAL POWER INTO ELECTRIC POWER USING PYROELECTRIC NANOPARTICLE COLLOIDAL SUSPENSION, DEVICE FOR IMPLEMENTING SAID METHOD, AND COLLOIDAL SUSPENSION USED

(30) Priorité: 03.11.2009 FR 0957776
(43) Date de publication de la demande: 12.09.2012
(73) Titulaire: Ferroenergy, 92120 Montrouge (FR)
(72) Inventeur: DELAHAYE, Thierry, F-92110 Clichy (FR)
(74) Mandataire: Cabinet Plasseraud
(86) Numéro de dépôt international: PCT/FR2010/052322
(87) Numéro de publication internationale: WO 2011/055065

(56) Documents cités:
- WO-A1-00/36656
- WO-A2-2009/126344
- US-A- 4 425 540
- US-A1- 2009 056 094
- VANDERPOOL D ET AL: "Simulations of a prototypical device using pyroelectric materials for harvesting waste heat", INTERNATIONAL JOURNAL OF HEAT AND MASS TRANSFER, PERGAMON PRESS, GB LNKD- DOI:10.1016/J.IJHEATMASSTRANSFER.2008.04.0 08, vol. 51, no. 21-22, 1 octobre 2008 (2008-10-01), pages 5052-5062, XP025409131, ISSN: 0017-9310 [extrait le 2008-06-26]
- GAEL SEBALD ET AL: "On thermoelectric and pyroelectric energy harvesting", SMART MATERIALS AND STRUCTURES, IOP PUBLISHING LTD., BRISTOL, GB, vol. 18, no. 12, 23 septembre 2009 (2009-09-23), page 125006, XP020168976, ISSN: 0964-1726

## Description

La présente invention concerne un procédé de conversion d'énergie thermique en énergie électrique utilisant une suspension colloïdale de nanoparticules pyroélectriques ainsi qu'un dispositif de conversion capable de mettre en oeuvre ledit procédé. Elle porte également sur la suspension colloïdale de nanoparticules pyroélectriques.

La plupart des moyens de génération électrique reposent sur l'utilisation de machines thermiques. Le procédé le plus employé pour convertir l'énergie thermique en énergie électrique est de faire subir un cycle thermodynamique à un fluide, généralement de l'eau. Le principe le plus classique est le suivant : de la vapeur haute pression est générée dans une chaudière ; cette vapeur est détendue dans une turbine qui entraîne un alternateur ; la vapeur basse pression est ensuite refroidie par échange de chaleur avec la source froide avant de retourner en entrée de la chaudière. Ce procédé a cependant une double limitation. D'une part, afin d'avoir une surface d'échangeurs de chaleur réaliste, il suppose d'avoir un écart de température suffisamment important entre la source chaude et la source froide. Par exemple, dans le cas d'une centrale électrique, la source froide étant l'eau de mer ou l'eau d'un fleuve à température ambiante, l'utilisation d'un cycle à la vapeur suppose une source chaude à plusieurs centaines de degrés. D'autre part, ces cycles ont une limitation de rendement. Par exemple, ce procédé mis en place dans une centrale nucléaire a en pratique un rendement global borné inférieurement à 35% d'un cycle de Carnot. La majeure partie de l'énergie produite sous forme de chaleur est perdue car elle ne peut pas être convertie, et finit par réchauffer l'environnement. On comprend dès lors que l'utilisation de technologies alternatives permettant d'augmenter ce rendement pourrait avoir un intérêt industriel très fort.

Il existe bien des procédés alternatifs de conversion d'énergie thermique en énergie électrique. Parmi ceux-ci, on peut citer l'utilisation d'un deuxième cycle thermodynamique, utilisant un deuxième fluide ayant une température d'ébullition inférieure au premier, l'utilisation de cellules photovoltaïques excitées par des sources de rayonnement dans l'infrarouge ou de cellules thermoélectriques. Néanmoins il est estimé que malgré leur intérêt, ces procédés ne sont pas à même d'aboutir à des installations électriques de puissance, à un coût compatible avec les exigences du marché.

Néanmoins, parmi ces procédés alternatifs, l'utilisation de l'effet pyroélectrique est jugée plus pertinente sur le plan industriel. Il s'agit d'utiliser des propriétés électriques particulières de certains matériaux ferroélectriques au voisinage de la température d'une de leurs transitions de phase autrement appelée température de Curie. La spécificité d'un matériau pyroélectrique est que sa capacité à se polariser électriquement varie fortement en fonction de la température, au voisinage de cette température de transition. De plus cette polarisation est classiquement fonction du champ électrique auquel est soumis le matériau. En jouant sur ces deux paramètres : température et champ électrique, on peut faire décrire à un matériau pyroélectrique un cycle thermodynamique appelé cycle de Olsen (Pyroelectric Conversion Cycles, J. App. Phys., 58, 4709 (1985)). Les matériaux utilisés sont généralement mis sous la forme de films minces de quelques microns d'épaisseur, qui sont ensuite assemblés en plaques. Différents procédés existent pour faire commuter la température de ces films et la différence de potentiel auquel ils sont soumis (US 4 425 540, US 6 528 898). On peut par ailleurs noter une technique pour améliorer le rendement global du procédé qui consiste à utiliser une gamme de matériaux pyroélectriques qui commutent «en cascade » à différentes températures s'échelonnant entre la source froide et la source chaude. Toutefois chaque transition génère une quantité d'électricité relativement faible Ce qui explique l'importance de chercher à concevoir un système permettant un grand nombre de commutations. Certaines recherches actuelles portent sur l'amélioration des technologies de commutation de température et de tension ainsi que sur l'amélioration des performances des matériaux pyroélectriques utilisés, notamment la réduction de la perte de polarisation à l'intérieur du matériau lui-même. Cependant, de par leur complexité et de par la surface de film pyroélectrique nécessaire, il est jugé peu vraisemblable que ce type de montage puisse aboutir à une réalisation industrielle viable sur le plan économique.

Le présent inventeur a trouvé que pour obtenir un procédé plus simple, transposable à l'échelle industrielle et viable économiquement, il fallait non pas faire commuter la température et la tension aux bornes de surfaces pyroélectriques fixes, mais déplacer le matériau pyroélectrique le long d'un chemin où la température et la différence de potentiel varient. Pour ce faire, il a trouvé qu'il était possible de mettre le matériau pyroélectrique sous la forme de nanoparticules et de former avec celles-ci une suspension colloïdale, ladite suspension colloïdale étant mise en mouvement. Cette façon de procéder permet de s'affranchir de toute commutation aussi bien de température que de tension.

La présente invention concerne donc un procédé de conversion d'énergie thermique en énergie électrique utilisant une suspension colloïdale de nanoparticules pyroélectriques. Ce procédé présente l'avantage d'être plus simple dans sa mise en oeuvre du fait de l'absence de systèmes complexes de commutation de température et de potentiel, de permettre un encombrement réduit du fait de l'absence de films pyroélectriques de grande surface, et de présenter une meilleure flexibilité notamment au niveau de la puissance électrique générée. Le procédé ici décrit permet de réaliser un grand nombre de cycles de Olsen dans un encombrement réduit et de délivrer ainsi des puissances électriques significatives à l'échelle industrielle.

Dans un souci de clarté rédactionnelle, les termes « suspension » et « suspension colloïdale » désignent dans cette demande de manière interchangeable la suspension colloïdale de nanoparticules pyroélectriques telle que définie dans la présente invention. La présente invention concerne un procédé de conversion d'énergie thermique en énergie électrique comprenant une étape consistant à faire subir au moins un cycle de Olsen à une suspension colloïdale de nanoparticules pyroélectriques.

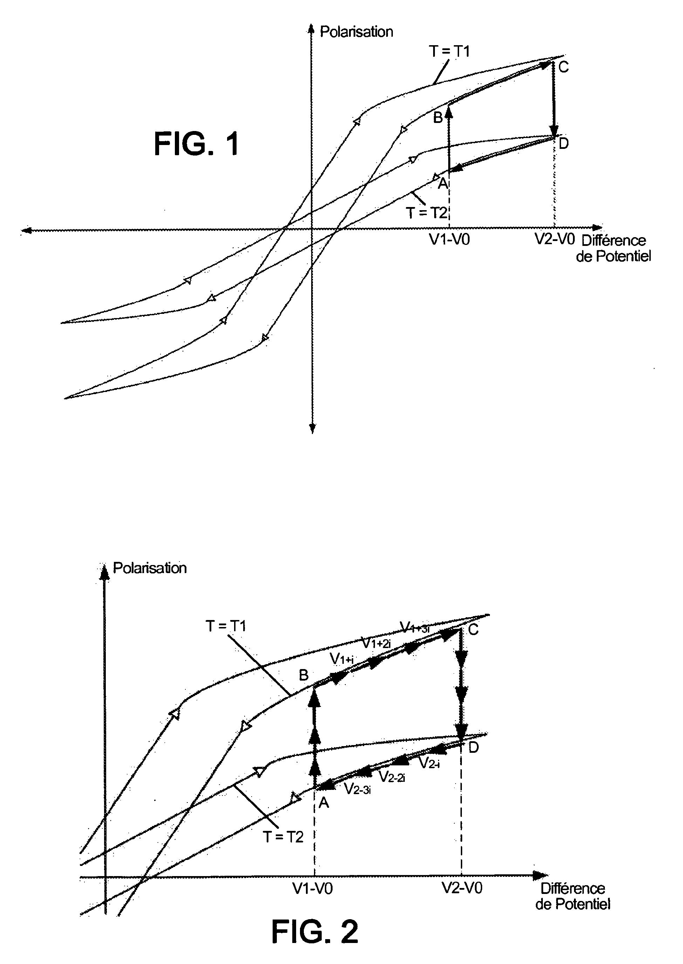

Le cycle de Olsen est un cycle thermodynamique décrit par Olsen et al. (Pyroelectric Conversion Cycles, J. App. Phys., 58, 4709 (1985)). Ce cycle, représenté schématiquement par le chemin ABCD sur la figure 1, est constitué de deux isothermes et deux isopotentiels.

Un procédé de conversion d'énergie thermique en énergie électrique utilisant un cycle Olsen est divulgué dans Vanderpool et al., Int. J. of Heat and Mass Transfer 51 (2008), 5052-5062.

La suspension colloïdale est maintenue tout au long du cycle sous un champ électrique tangentiel à deux plaques soumises à une différence de potentiel. Au point A, la suspension colloïdale de nanoparticules pyroélectriques se trouve à une température haute (T2) et à une différence de potentiel basse (V1-V0). La suspension est alors refroidie à la température T1. En décrivant le segment AB, les nanoparticules pyroélectriques accroissent leur polarisation. Cet accroissement de polarisation se manifeste par un courant de charge qui peut provenir d'un circuit électrique extérieur. Le potentiel est encore accru le long du segment BC jusqu'à la valeur V2-V0, permettant ainsi une repolarisation maximale des nanoparticules pyroélectriques. Au point C, la suspension colloïdale de particules pyroélectriques se trouve à une température basse (T1) et est soumise à une différence de potentiel haute (V2-V0). La polarisation des particules pyroélectriques est alors maximale. La suspension est ensuite chauffée jusqu'à une température haute (T2), la différence de potentiel étant maintenue à V2-V0, (D). En décrivant le segment CD, les particules se dépolarisent, ce qui se traduit par la formation d'un courant de décharge qui peut être récupéré via un circuit électrique extérieur. La différence de potentiel est ensuite réduite jusqu'à une valeur basse (V1-V0) pour poursuivre la dépolarisation des nanoparticules pyroélectriques jusqu'à atteindre le point A. La suspension est ainsi revenue dans les mêmes conditions qu'initialement décrites au point A, bouclant ainsi le cycle.

Ainsi, le procédé de l'invention comporte les étapes suivantes :
a) Maintenir la suspension à une différence de potentiel haute V2-V0 tout en chauffant la suspension d'une température froide T1 jusqu'à une température chaude T2 (figure 1, segment CD);
b) Réduire la différence de potentiel de la valeur haute V2-V0 à la valeur basse V1-V0, tout en maintenant la suspension à la température chaude T2 (figure 1, segment DA);
c) Maintenir la différence de potentiel basse V1-V0 tout en refroidissant la suspension de la température haute T2 jusqu'à une température basse T1 (figure1, segment AB);
d) Augmenter la différence de potentiel de la valeur basse V1-V0 à la valeur haute V2-V0, tout en maintenant la suspension à la température basse T1 (figure 1, segment BC);
où la température T1 est inférieure à la température T2 et la différence de potentiel V1-V0 est inférieure à la différence de potentiel V2-V0, V0 étant un potentiel de référence.

Les températures T1 et T2 se situent au voisinage de la température de Curie Tc d'une transition de phase paraélectrique-ferroélectrique, de préférence, T1 et T2 sont inférieures à la température de Curie. En particulier, l'écart entre T1 et T2 est de quelques dizaines de degrés Kelvin. Selon le matériau utilisé, Tc peut présenter différentes valeurs en fonction de l'application choisie. Pour certains matériaux, la température de Curie Tc peut être proche de la température ambiante. La différence de potentiel V2-V0 est choisie de façon à atteindre une charge substantiellement maximale du matériau pyroélectrique, tout en restant en-dessous du niveau de saturation. De préférence, V2-V0 est située à une valeur proche de la tension de claquage (Vc) du matériau pyroélectrique utilisé et inférieure à celle-ci. La différence de potentiel V1-V0 est située à une valeur faible de quelques centaines de volt par millimètre afin de maximiser le travail récupéré par cycle, tout en permettant la persistance d'un ordre local au sein de la suspension colloïdale.

Dans un mode de réalisation préféré, le passage de la différence de potentiel V1-V0 à la différence de potentiel V2-V0 se fait par plusieurs paliers intermédiaires. Dans ce mode de réalisation particulier, le procédé selon l'invention comprend les étapes suivantes :
a) Maintenir une différence de potentiel V2-V0, tout en chauffant la suspension jusqu'à une température T2;
b) Appliquer à la suspension maintenue à la température T2 une différence de potentiel constante égale à celle de l'étape précédente abaissée d'une valeur i;
b') Répéter l'étape b) jusqu'à atteindre la différence de potentiel V1-V0 ;
c) Maintenir la différence de potentiel V1-V0 tout en refroidissant la suspension jusqu'à une température T1 ;
d) Appliquer à la suspension maintenue à la température T1 une différence de potentiel constante égale à celle de l'étape précédente augmentée d'une valeur i;
d') Répéter l'étape d) jusqu'à atteindre la différence de potentiel V2-V0.
i étant un intervalle de potentiel approximativement égal à (V2-V1)/n, n étant le nombre de répétitions des étapes b et d ci-dessus.

Dans le procédé selon l'invention, les modifications de température et de potentiel sont réalisées par déplacement de la suspension colloïdale entre des électrodes planes fixes maintenues à différentes températures et/ou à différents potentiels. Ce déplacement de la suspension colloïdale est tel qu'il perturbe au minimum la stabilité de la suspension. Ainsi, on évitera d'appliquer des forces centrifuges trop intenses.

La présente invention concerne également un dispositif permettant de mettre en oeuvre le procédé de conversion d'énergie thermique en énergie électrique décrit ci-dessus.

Le dispositif de conversion d'énergie thermique en énergie électrique utilisant une suspension colloïdale de nanoparticules pyroélectriques comprend:
- des moyens de mise en circulation de ladite suspension ;
- des moyens de transfert thermique permettant de faire varier la température de ladite suspension ;
- des moyens pour appliquer différents potentiels à ladite suspension ;
- des moyens de récupération de l'énergie électrique générée.

Les moyens de mise en circulation de la suspension colloïdale de nanoparticules pyroélectriques sont tels qu'ils permettent un déplacement de ladite suspension sans modification de sa stabilité. En particulier, ces moyens exercent un minimum de forces centrifuges. Une pompe électromagnétique comme moyen de mise en circulation dans le dispositif de l'invention est tout à fait adaptée.

Les moyens de transfert thermique permettant de faire varier la température de ladite suspension sont deux échangeurs thermiques : un échangeur thermique dans lequel circule un fluide caloporteur échangeant avec la source froide, et un échangeur thermique dans lequel circule un fluide caloporteur échangeant avec la source chaude. L'échangeur thermique dans lequel circule le fluide froid doit permettre de porter la température de la suspension colloïdale à la température minimale du cycle de la suspension colloïdale égale à T1 ; et l'échangeur thermique dans lequel circule le fluide chaud doit permettre de porter la température de la suspension colloïdale à une température maximale égale à T2.

Les moyens pour appliquer des potentiels différents à ladite suspension comprennent par exemple des électrodes reliées à un dispositif permettant d'imposer un potentiel tel que des générateurs de tension continue. Selon un mode de réalisation particulier, les générateurs de tension continue sont des générateurs à grande impédance de sortie. Lesdites électrodes sont en contact avec la suspension colloïdale lorsque le dispositif est en fonctionnement.

Dans un mode de réalisation particulier, lesdites électrodes sont constituées d'une multitude de plaques parallèles disposées le long du parcours de la suspension. Les plaques parallèles sont reliées les unes à un potentiel de référence V0, les autres, de manière indépendante sont reliées aux bornes d'un générateur de tension continue. La différence de potentiel entre un couple de plaques peut être ainsi fixée indépendamment des autres couples de plaques. Les plaques sont disposées le long du parcours de la suspension de sorte que, en fonctionnement, la suspension passe successivement entre chaque couple de plaques parallèles où elle est soumise à des potentiels différents.

Dans un mode de réalisation préféré, chaque échangeur est constitué de deux circuits entrelacés le premier permettant la circulation d'un fluide caloporteur chaud ou froid, provenant respectivement de la source chaude ou de la source froide, le second permettant la circulation de la suspension colloïdale. Sur ce second circuit sont disposées les plaques conductrices permettant d'appliquer un potentiel. Les échangeurs peuvent ainsi former une structure compacte favorisant les échanges thermiques entre le fluide caloporteur et la suspension. De plus, cette structure permet le passage de la suspension entre chaque couple de plaques tout en maintenant une isolation électrique entre les plaques. Un échangeur froid est associé à un échangeur chaud de telle sorte qu'en fonctionnement, la suspension puisse passer de l'échangeur chaud à l'échangeur froid et vice-versa. L'ensemble composé de ces deux échangeurs est appelé unité de conversion. Le dispositif selon l'invention comporte plusieurs unités de conversion. Dans chacune des ces unités de conversion, la suspension subit un cycle de Olsen complet. Le nombre d'unités de conversion dépend bien évidemment de la puissance électrique que l'on souhaite générer. Selon les applications, ce nombre pourra être de quelques unités à quelques milliers d'unités. On se place ainsi respectivement dans une technologie d'échangeurs classiques à plaques ou dans une technologie de micro-échangeurs.

Les plaques sont reliées à des moyens de récupération de l'énergie électrique générée comprenant tout circuit extérieur capable de collecter et convertir l'énergie électrique générée. Le courant peut être par exemple transformé dans un hacheur et éventuellement un onduleur afin de générer du courant utilisable par des équipements électriques en aval : soit en courant continu, soit en courant alternatif.

Le dispositif peut également comporter des dérivations qui offrent la possibilité de court-circuiter une ou plusieurs unités de conversion : soit pour réguler la puissance électrique produite, soit pour permettre la maintenance de certaines unités de conversion.

Lorsque le dispositif est mis en oeuvre, la suspension, mise en circulation par des moyens appropriés, passe successivement d'un échangeur avec la source chaude à un échangeur avec la source froide et, au cours de ce parcours, des différences de potentiel différentes lui sont appliquées. La différence de potentiel appliquée à la suspension à une température froide T1 peut être augmentée à une valeur haute V2-V0 pendant que la suspension est chauffée par mise en contact avec l'échangeur chaud jusqu'à une température chaude T2, température à laquelle la différence de potentiel est abaissée à une valeur basse V1-V0; cette différence de potentiel est maintenue à V1-V0 pendant que la suspension est refroidie par mise en contact avec l'échangeur froid jusqu'à la température froide Tel ; lorsque la suspension atteint la température froide T1 la différence de potentiel est montée à une valeur haute V2-V0. De préférence, les passages des différences de potentiel V1-V0 à V2-V0 et inversement sont effectuées de manière progressive en appliquant à la suspension une multitude de potentiels paliers intermédiaires, en augmentant ou diminuant le potentiel d'un intervalle de potentiel i à chaque palier, afin de décrire au plus près les segments isothermes BC et DA du cycle de Olsen (figure 2). L'intervalle i est défini tel que i=(V2-V1)/n, n étant le nombre de paliers de potentiels choisi.

La circulation de la suspension va être décrite ci-après en lien avec l'échangeur traversé par le fluide chaud. Dans une première partie de l'échangeur (zone A), la suspension est chauffée par transfert thermique avec le fluide caloporteur chaud pour atteindre la température chaude T2. Dans cette partie, la différence de potentiel appliquée à la suspension est maintenue constante V2-V0. Dans la seconde partie de l'échangeur (zone B), la température de la suspension est considérée comme sensiblement constante égale à T2. La différence de potentiel appliquée à chaque plaque diminue quant à elle graduellement de sorte que la dernière plaque de l'échangeur présente une différence de potentiel V1-V0. Ainsi, lorsque la suspension parcourt la zone A, elle décrit le segment CD du cycle de Olsen et lorsqu'elle parcourt la zone B, elle décrit le segment DA du cycle de Olsen. De façon analogue, la circulation de la suspension dans l'échangeur va maintenant être décrite ci-après en lien avec l'échangeur traversé par le fluide froid. Dans une première partie de l'échangeur (zone A), la suspension est refroidie par transfert thermique avec le fluide caloporteur froid pour atteindre la température froide T1. Dans cette partie, la différence de potentiel appliquée à la suspension est maintenue constante V1-V0. Dans la seconde partie de l'échangeur (zone B), la température de la suspension est considérée comme sensiblement constante égale à T1. La différence de potentiel appliquée à chaque plaque augmente quant à elle graduellement de sorte que la dernière plaque de l'échangeur présente une différence de potentiel V2-V0. Ainsi, lorsque la suspension parcourt la zone A, elle décrit le segment AB du cycle de Olsen et lorsqu'elle parcourt la zone B, elle décrit le segment BC du cycle de Olsen. Une unité de conversion formée permet donc de faire décrire à la suspension un cycle de Olsen complet permettant la production d'énergie électrique.

La clé de l'efficacité du dispositif est de pouvoir effectuer le plus grand nombre de cycles de Olsen dans un volume compact, ce qui suppose une grande surface d'échange et une miniaturisation de la taille des canaux. En contrepartie cela augmente les pertes de charges et donc l'énergie perdue par pompage. Le dimensionnement des canaux des échangeurs est le résultat d'une optimisation de ces deux effets opposés.

Le dispositif selon l'invention peut également comprendre des moyens de contrôle et/ou de maintenance. De tels moyens peuvent comprendre au moins un hydrocyclone placé en parallèle du circuit principal de circulation de la suspension colloïdale. Cet hydrocyclone permet de contrôler la concentration en particules pyroélectriques de la suspension colloïdale. Il permet ainsi de séparer complètement les particules du milieu de suspension, en vue d'un arrêt du dispositif par exemple, puis également l'introduction progressive des particules lors du redémarrage. L'hydrocyclone permet également de contrôler le vieillissement des particules par érosion à travers un contrôle de leur taille. Un système associé peut alors éliminer les particules anciennes et les remplacer par des particules neuves.

Les moyens de contrôle peuvent également comprendre un analyseur en ligne destiné à contrôler la distribution de taille des particules. Il peut s'agir notamment d'une caméra vidéo numérique placée derrière un microscope électronique focalisant sur une petite dérivation en parallèle du circuit principal de circulation de la suspension. Les images sont analysées par traitement d'image numérique pour fournir une distribution de taille. D'autres moyens peuvent consister en des points de prélèvement de la suspension colloïdale disposés en dérivation du circuit principal de circulation de la suspension colloïdale pour permettre d'autres contrôles en laboratoire de la suspension.

Le procédé et le dispositif selon l'invention vont être décrits ci-après plus précisément en lien avec les dessins annexés sur lesquels :
La figure 1 est un graphique illustrant le principe du cycle thermodynamique de Olsen ;
La figure 2 est un détail de la figure 1 qui indique le chemin thermodynamique subi par la suspension colloïdale au cours du passage dans une unité de conversion du dispositif selon l'invention ;
La figure 3 est une représentation schématique en perspective d'une demi-unité de conversion selon l'invention ;
La figure 4 est une coupe selon le plan P1 de la figure 3 ;
La figure 5 est une coupe selon le plan P2 de la figure 3 ;
La figure 6 est une représentation schématique des flux traversants une unité de conversion du dispositif selon l'invention ;
La figure 7 est une représentation schématique du circuit électrique d'une unité de conversion du dispositif selon l'invention ;
La figure 8 est le diagramme des flux permettant l'alimentation et le contrôle des flux représentés sur la figure 6.

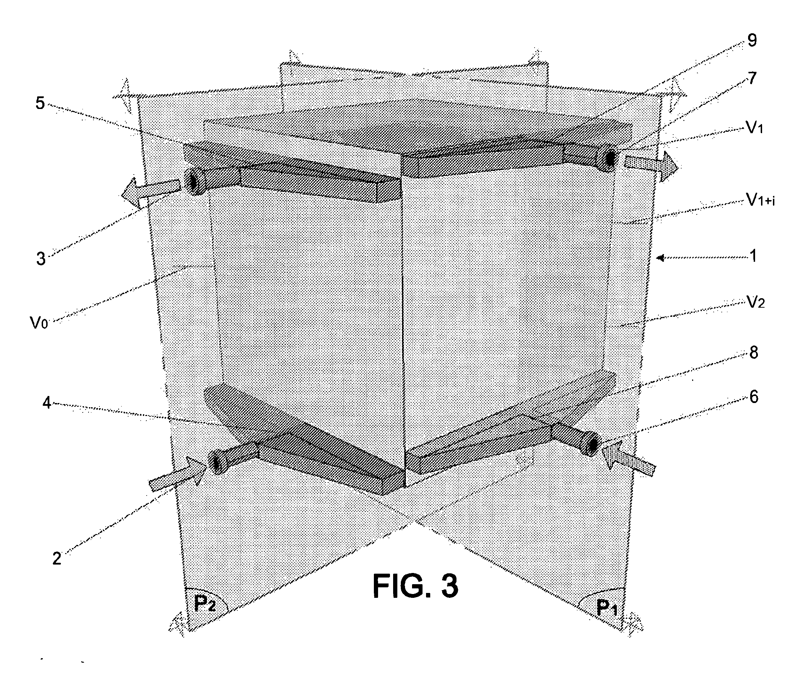

La figure 3 montre une vue schématique en perspective d'une demi-unité de conversion 1 du dispositif de l'invention. Le conduit d'arrivée du fluide caloporteur est représenté en 2 et le conduit de sortie est représenté en 3. Le fluide caloporteur se déplace donc dans un serpentin formé de plaques parallèles. Sur la figure 3, sont représentés les collecteurs des plaques d'arrivée 4 et de sortie 5 du fluide caloporteur. Perpendiculairement à ce serpentin dans lequel circule le fluide caloporteur est imbriqué un serpentin destiné à recevoir la suspension colloïdale. Sur la figure 3 sont représentés le conduit d'arrivée 6 de la suspension colloïdale et le conduit de sortie 7 de celle-ci. Le serpentin destiné à recevoir la suspension colloïdale est constitué par des plaques parallèles. Sont représentés également sur la figure 3 les collecteurs des plaques d'arrivée 8 de la suspension et de sortie 9 de celle-ci. La figure 3 représente également les connecteurs électriques, reliés à un circuit électrique extérieur non représenté sur cette figure, aux potentiels V0, V1, V1+i et V2.

L'unité de conversion 1 représentée sur les figures en coupe 4 et 5 comprend deux circuits entrelacés, l'un transportant le fluide caloporteur 10 et le second transportant la suspension 11. Sur l'exemple représenté ici, il comporte huit plateaux les uns 12 destinés à recevoir le fluide caloporteur et les autres 13 destinés à recevoir la suspension. Les dimensions des canaux des échangeurs sont choisies de telle sorte que les échanges thermiques entre le fluide caloporteur 10 et la suspension 11 soient suffisants au cours des quatre premiers plateaux que forme la zone A, pour considérer que la température de la suspension soit sensiblement constante égale à T2 (respectivement T1 pour un échangeur à source froide) dans les quatre derniers plateaux que forme la zone B. Les plaques 14a et 14b parallèles deux à deux disposées à chaque plateau de part et d'autre du passage de la suspension 11 forment des électrodes. Pour chaque couple de plaques, l'une des plaques 14a est reliée à un potentiel de référence V0, tandis que la seconde plaque 14b est reliée à un générateur de tension continue afin d'imposer à ladite plaque le potentiel désiré. Ainsi, dans la zone A, un potentiel identique V1 (respectivement V2 pour un échangeur à source chaude) est appliqué aux secondes plaques 14b. Dans la zone B, un potentiel différent est imposé aux plaques 14c (par exemple V1+i) et 14d (par exemple V1), V1 étant inférieur à V1+i et V1+i étant inférieur à V2. Dans le cas d'un échangeur à source froide ces potentiels sont croissants.

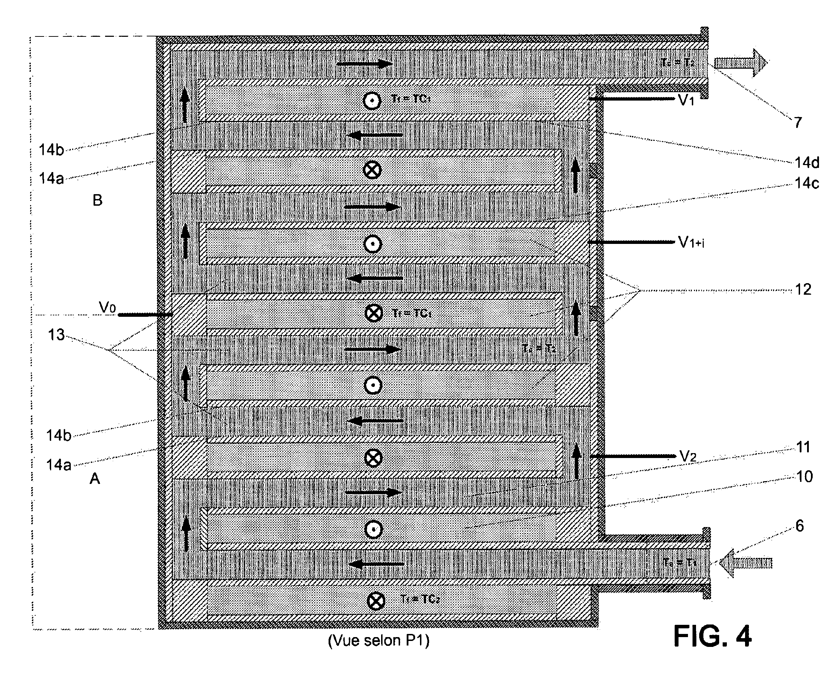

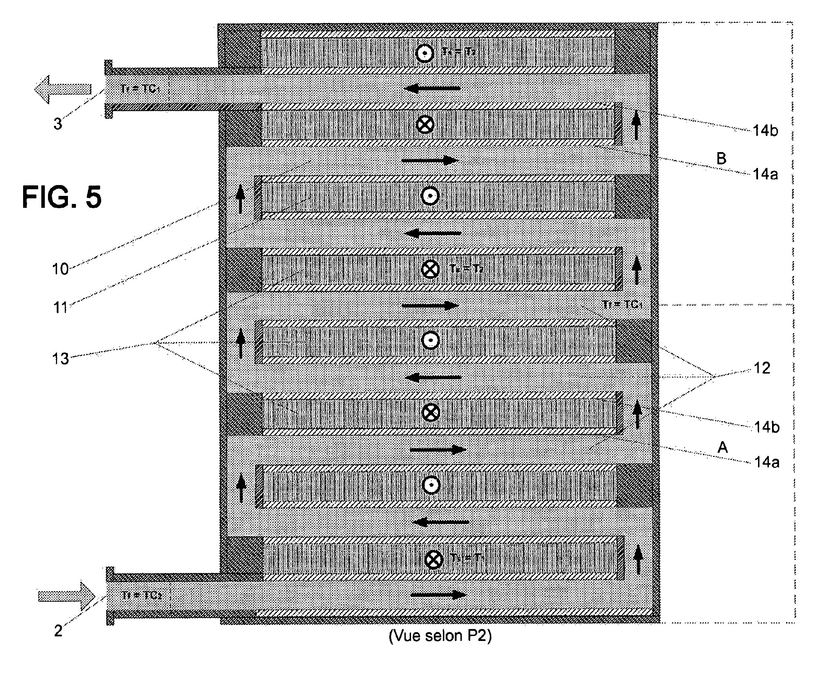

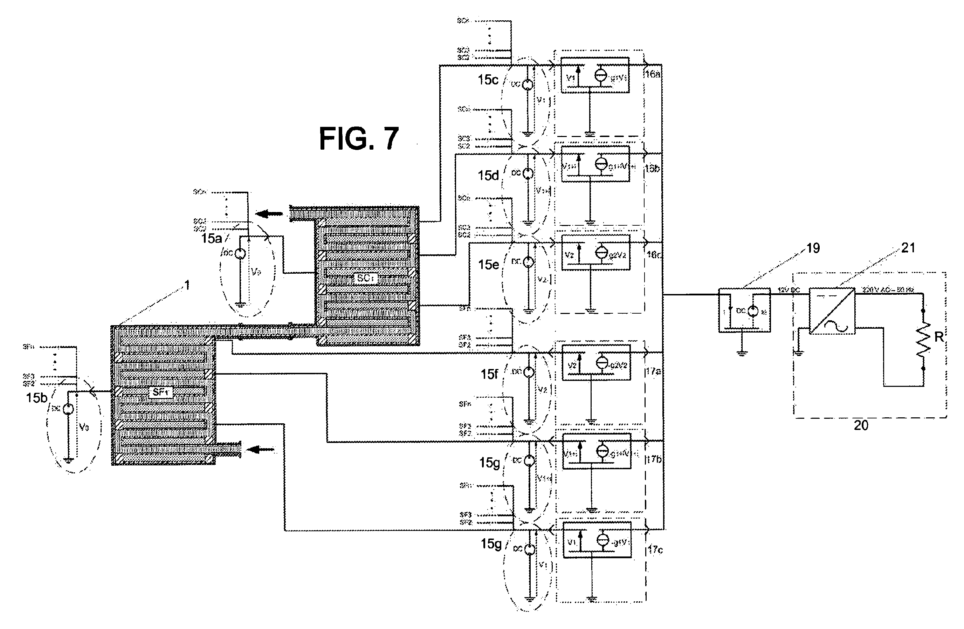

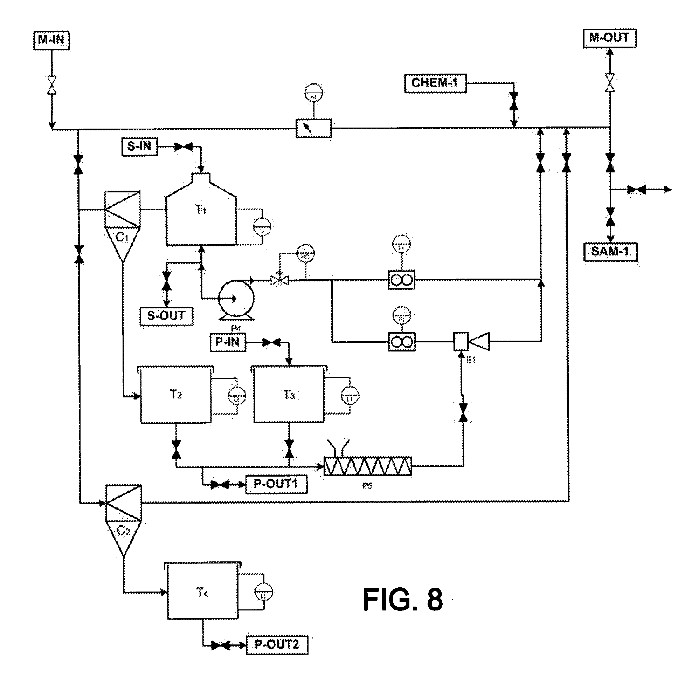

Les plaques sont les électrodes qui vont successivement fournir et absorber de la charge électrique au cours du cycle. Elles sont reliées à un circuit électrique extérieur 15. Les plaques sont constituées d'un matériau conducteur peu résistif et ayant une bonne rigidité mécanique (représenté en blanc hachuré sur les figures 4 et 5). Le matériau hachuré en gris est lui un matériau isolant ayant une bonne rigidité mécanique. Sur la figure 7, on a représenté une unité de conversion complète comprenant un échangeur de source chaude (SC1) et un échangeur de source froide (SF1). Les circuits électriques sont représentés. Ainsi, l'unité de conversion est reliée à deux branches électriques 15a et 15b connectées à un générateur délivrant un potentiel V0, et à 6 autres branches électriques 15c à 15h connectées à des générateurs délivrant des potentiels différents, respectivement V1, V1+i, V2, V2, V2-i, V1. Sur l'exemple de la figure 7, un seul niveau de tension intermédiaire V1+i=V2-i a été représenté. Chaque plaque peut ainsi être assimilée à une mini-pile électrique débitant un micro-courant électrique avec une différence de potentiel élevée Vx-V0 (x valant 1, 1+i, 2-i ou 2). Ces micro-courants haute tension sont convertis à un même niveau de tension pour pouvoir être sommés à l'aide de convertisseur de tension continue qui soit conserve le sens du courant 16a, 16b, 16c, soit l'inverse 17a, 17b,17c. Ces micro-courants rassemblés sont ensuite convertis en une tension continue basse tension à l'aide du circuit de conversion 19 (12V continu dans l'exemple de la figure 8). A l'aide d'un autre convertisseur de tension continue 20, ce courant continu peut éventuellement être converti en courant alternatif d'un réseau électrique à l'aide d'un onduleur 21. La résistance R est ici représentée juste pour indiquer le réseau électrique extérieur avec tous ses consommateurs de puissance.

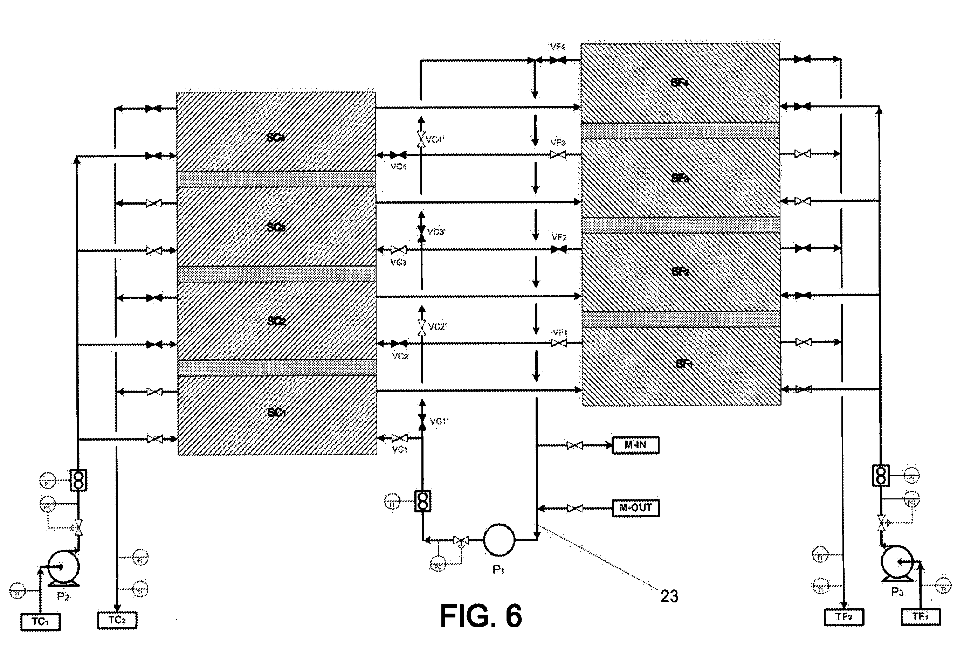

Sur la figure 6, on a représenté schématiquement un dispositif selon l'invention comprenant 4 unités de conversion : chacune comprenant un échangeur de source froide SFi et un échangeur de source chaude SCi (SF1-SC1, SF2-SC2, SF3-SC3, SF4-SC4). En fonctionnement, la suspension est mise en circulation par la pompe P1. Elle circule en circuit fermé 23 et passe successivement d'une source chaude (SC) à une source froide (SF) et subit ainsi un cycle thermique dans chaque unité de conversion traversée. Dans ce mode de réalisation, les échangeurs sont des échangeurs à plateaux à contre-courant. Les échangeurs à source chaude (SC) et à source froide (SF) sont symétriques et se différencient uniquement par la température et, éventuellement, par la nature du fluide caloporteur. Les fluides caloporteurs sont mis en circulation par une pompe P2 pour le fluide chaud et P3 pour le fluide froid.

Pour chaque section de l'ensemble chaud, le fluide caloporteur entre avec une température TC1 et ressort avec une température TC2 < TC1, tandis que la suspension colloïdale passe de T1 à T2. Pour chaque section de l'ensemble froid, le fluide caloporteur entre avec une température TF1 et ressort avec une température TF2 > TF1, tandis que la suspension passe de T2 à T1.

Un système de vannes permet d'isoler certains étages du procédé. Ainsi sur la figure 6, les étages 1 (SC1+SF1) et 3 (SC3+SF3) sont en fonctionnement, tandis que les étages 2 (SC2 + SF2) et 4 (SC4+SF4) sont déconnectés. Ainsi, la suspension colloïdale est pompée par la pompe P1 et traverse l'échangeur SC1 puis l'échangeur SF1, les vannes Vc2 et Vf2 étant fermées, la suspension traverse directement l'échangeur SC3 puis SF3 et finit ainsi son cycle étant donné que les vannes Vc4 et Vf4 sont elles aussi fermées.

Sur le circuit 23 de la suspension colloïdale, sont disposées deux connections M-IN et M-OUT faisant la jonction avec un circuit secondaire optionnel permettant le contrôle de la qualité de la suspension colloïdale et la maintenance du circuit. Ce circuit secondaire est représenté sur la figure 8.

Le circuit secondaire contient 2 séries d'hydrocyclones : C1 et C2. L'ensemble C1 permet de contrôler la concentration et le remplacement dans le temps des nanoparticules pyroélectriques. Les particules séparées sont transférées dans un réservoir de stockage T2, tandis que le milieu de suspension est transféré dans le réservoir T1. Les particules du réservoir T2, ainsi que des particules neuves provenant du réservoir T3 peuvent être réintroduites dans le circuit 23 par un injecteur E1. Le milieu de suspension ainsi que des additifs peuvent être introduits par le point S-IN ou retirés par le point S-OUT. Les particules neuves peuvent être introduites par le point P-IN et les particules usées peuvent être retirées par le point P-OUT1.

L'ensemble C2 permet de retirer spécifiquement les nanoparticules pyroélectriques en dessous d'une certaine taille. Ces nanoparticules sont stockées dans le réservoir T4 avant d'être retirées du procédé par le point P-OUT2.

Ces 2 ensembles C1+C2 permettent de contrôler la concentration et le vieillissement des particules. Lors d'un arrêt pour maintenance, les particules sont d'abord retirées du procédé avant éventuellement de retirer le solvant. Lors d'un redémarrage, les particules sont réinjectées progressivement jusqu'à la concentration optimale.

Le contrôle en ligne de la distribution de taille des particules peut être effectué grâce à l'analyseur en ligne AI. Celui-ci est constitué d'une caméra vidéo numérique placée derrière un microscope électronique focalisant sur une petite dérivation en parallèle du circuit 23. Les images sont analysées par traitement d'image numérique pour fournir une distribution de taille.

Enfin des points SAM-1 sont prévus pour échantillonner la suspension colloïdale pour des analyses en laboratoire et des points CHEM-1 sont prévus pour injecter des additifs, tels que les agents stabilisants ou des inhibiteurs de corrosion.

Les modes de réalisation représentés sur les figures décrites précédemment sont donnés à titre d'exemple uniquement et ne sont en aucun cas limitatifs.

La présente invention concerne également une suspension colloïdale de nanoparticules pyroélectriques.

La suspension colloïdale a des propriétés proches d'un solide pour ce qui est de ses propriétés électriques et proches d'un liquide pour ce qui est de ses propriétés mécaniques (notamment sa viscosité, qui doit être faible).

La suspension colloïdale de nanoparticules pyroélectriques, selon l'invention, comprend lesdites nanoparticules en suspension dans un milieu conducteur, et éventuellement un agent stabilisant et un porteur de charges.

La concentration en particules doit permettre un effet pyroélectrique important, tout en restant suffisamment faible pour ne pas induire des interactions trop fortes des nanoparticules avec leurs plus proches voisins, interactions qui viendraient accroître grandement la viscosité du milieu.

Selon un mode de réalisation particulier, ladite suspension colloïdale comprend entre 1% et 60% volumique de nanoparticules pyroélectriques, de préférence de 10 à 50%, plus préférentiellement de 20% à 40%, et plus préférentiellement encore environ 30%, lesdits pourcentages étant des pourcentages en volume par rapport au volume total de la suspension.

Le milieu de la suspension est suffisamment conducteur pour permettre la transmission des charges des nanoparticules vers les plaques afin de récupérer l'énergie électrique générée dans un circuit électrique extérieur, tout en restant suffisamment isolant pour éviter la recombinaison de charges entre les nanoparticules elles-mêmes. Comme milieu de suspension, on peut utiliser un mélange d'une solution aqueuse conductrice et d'une solution organique non conductrice miscible à la première. Ainsi, en jouant sur les proportions respectives de solution aqueuse/solution organique, il est possible d'adapter la conductivité du milieu. La solution organique est un liquide de faible viscosité dans la plage de température de mise en oeuvre du procédé, de faible tension de vapeur, de conductivité faible, très miscible à l'eau et ayant une bonne stabilité chimique dans cette plage de température. Le diéthylène glycol peut par exemple être utilisé. De préférence, le milieu de suspension est un mélange d'eau et de diéthylène glycol. Plus préférentiellement, le solvant utilisé est un mélange 30% vol eau - 70 %vol diéthylene glycol.

Au moins un porteur de charges est introduit dans la suspension afin de permettre le transport de charge de particule à particule dans une direction tangentielle aux plans formés par les plaques. Ces porteurs de charges peuvent être des nanoparticules, de TiO₂ notamment, ou bien des ions en solution, le transport de charges se faisant par un mécanisme redox. A titre d'exemples, on peut citer des sels classiques d'halogénures de métaux alcalins/alcalino-terreux, et notamment le chlorure de potassium.

Les nanoparticules peuvent être stabilisées par un agent stabilisant qui peut être choisi parmi les agents tensioactifs, les polymères engendrant un effet de gène stérique, et leurs mélanges. A titre d'exemple, on peut utiliser le polyéthylène glycol, et notamment le PEG-300.

La suspension colloïdale peut en outre comprendre des inhibiteurs de corrosion.

La suspension colloïdale est composée de nanoparticules dont la taille est suffisamment importante pour permettre un effet pyroélectrique notable et suffisamment faible pour assurer la stabilité de la suspension. De préférence, les nanoparticules ont une taille comprise entre 50 et 500nm. Les particules sont soit sphériques, soit sous forme de bâtonnets, allongés selon l'axe de polarisation.

Les nanoparticules pyroélectriques utilisées sont soit des oxydes ferroélectriques à structure perovskites comme par exemple BaTiO₃, SrₓBa₁₋ₓNb₂O₆, Pb(ZrₓTi₁₋ₓ)O₃ (PZT) ou xPb(Mg_{1/3}Nb_{2/3})O₃-(1-x)PbTiO₃ (PMN-PT), soit des polymères comme par exemple le polyfluorure de vinyle (PVF), le polyfluorure de vinylidène (PVDF), le tétrafluoroéthylène (TrFE) ou le poly(fluorure de vinylidène/tétrafluoroéthylène) (PDVF-TrFE), soit des composites des deux espèces.

L'invention porte également sur l'utilisation du dispositif et du procédé décrits précédemment pour améliorer le rendement électrique des machines thermiques industrielles, pour permettre le développement des énergies renouvelables thermiques ou pour récupérer l'énergie d'échappement des moteurs thermiques.

Ainsi, selon la première application, le dispositif selon l'invention est utilisé par exemple dans une centrale à vapeur d'une industrie de procédé (chimie, raffinage ...), dans un système de récupération de calories (réseau huile chaude sur un échappement de turbine à gaz par exemple ...), ou dans la boucle vapeur d'une centrale thermique à énergie fossile (pétrole, charbon, gaz ...) ou nucléaire. Dans ce dernier cas, il est par exemple installé en parallèle de la branche condenseur - tour de réfrigération pour récupérer sous forme électrique une partie de l'énergie thermique du fluide chaud ayant perdu son énergie de pression (vapeur basse pression dans le cas d'un cycle à la vapeur). Il est alors possible d'améliorer le rendement électrique global d'une installation tout en restituant moins de chaleur à la source froide, c'est-à-dire en minimisant l'impact sur l'environnement.

Le dispositif selon l'invention peut également être avantageusement utilisé pour développer les énergies renouvelables thermiques, en particulier la géothermie et les chauffe-eau solaires, et de manière générale toutes les situations où de l'énergie thermique est produite mais l'écart de température avec la source froide n'est pas suffisant pour permettre la mise en place, de façon économique, d'une boucle de production d'électricité avec un cycle thermodynamique à fluide classique.

Le dispositif et le procédé selon l'invention peuvent également permettre la production d'électricité en récupérant une partie de l'énergie thermique produite par les lignes d'échappement des moteurs thermiques embarqués à bord de véhicules, notamment des navires, des avions, des camions ou des voitures particulières.

## Revendications

1. Procédé de conversion d'énergie thermique en énergie électrique comprenant une étape consistant à faire subir au moins un cycle de Olsen à une suspension colloïdale de nanoparticules pyroélectriques.

2. Procédé selon la revendication 1, **caractérisé en ce que** les températures T1 et T2 des deux isothermes du cycle de Olsen sont choisies telles que Tlet T2 soient au voisinage de Tc.

3. Procédé selon la revendication 1, **caractérisé en ce que** les potentiels V 1 et V2 des deux isopotentiels du cycle de Olsen sont choisis tels que V1 est inférieur à V2, de préférence V2 a une valeur inférieure à la tension de claquage (Vc) du matériau pyroélectrique utilisé.

4. Procédé selon l'une quelconque des revendications 1 à 3, comprenant les étapes suivantes :
a) Maintenir une différence de potentiel V2-V0 tout en chauffant la suspension jusqu'à une température T2 ;
b) Diminuer la différence de potentiel jusqu'à V1-V0, tout en maintenant la suspension à la température T2 ;
c) Maintenir la différence de potentiel V1- V0, tout en refroidissant la suspension jusqu'à une température T1 ;
d) Augmenter la différence de potentiel jusqu'à V2-V0, tout en maintenant la suspension à une température T1 ;
où la température T1 est inférieure à la température T2 et la différence de potentiel V1-V0 est inférieure à la différence de potentiel V2-V0.

5. Procédé selon l'une quelconque des revendications 1 à 4, comprenant les étapes suivantes :
a) Maintenir la différence de potentiel V2-V0, tout en chauffant la suspension jusqu'à une température T2;
b) Appliquer à la suspension maintenue à la température T2 une différence de potentiel constante égale à celle de l'étape précédente abaissée d'une valeur i;
b') Répéter l'étape b) jusqu'à atteindre la différence de potentiel V1-V0 ;
c) Maintenir la différence de potentiel V1-V0 tout en refroidissant la suspension jusqu'à une température T1 ;
d) Appliquer à la suspension maintenue à une température T1 une différence de potentiel constante égale à celle de l'étape précédente augmentée d'une valeur i;
d') Répéter l'étape d) jusqu'à atteindre la différence de potentiel V2-V0 ;
i étant un intervalle de potentiel approximativement égal à (V2-V1)/n, n étant le nombre de répétitions des étapes b et d ci-dessus.

6. Dispositif de conversion d'énergie thermique en énergie électrique selon le procédé d'une quelconque des revendications 1 à 3 comprenant :
- des moyens de mise en circulation de ladite suspension ;
- des moyens de transfert thermique permettant de faire varier la température de ladite suspension ;
- des moyens pour appliquer un potentiel variable à ladite suspension ;
- des moyens de récupération de l'énergie électrique générée.

7. Dispositif selon la revendication 6, **caractérisé en ce que** les moyens de mise en circulation de la suspension comprennent une pompe électromagnétique.

8. Dispositif selon la revendication 6 ou 7, **caractérisé en ce que** les moyens de transfert thermique comprennent au moins deux échangeurs thermiques.

9. Dispositif selon l'une quelconque des revendications 6 à 8, comprenant plusieurs couples d'échangeurs thermiques, chaque échangeur thermique étant constitué de deux circuits entrelacés le premier permettant la circulation d'un fluide caloporteur chaud ou froid, échangeant respectivement avec la source chaude ou froide, le second permettant la circulation de la suspension colloïdale, sur ce second circuit sont disposées des plaques conductrices permettant d'appliquer un potentiel, chaque échangeur froid étant associé à un échangeur chaud de telle sorte qu'en fonctionnement, la suspension puisse passer d'un échangeur chaud à un échangeur froid et vice-versa.

10. Dispositif selon l'une quelconque des revendications 6 à 9, **caractérisé en ce que** les moyens de récupération de l'énergie électrique comprennent un onduleur capable de convertir l'énergie générée en courant continu ou en courant alternatif.

11. Suspension colloïdale de nanoparticules pyroélectriques comprenant entre 1% et 60% de nanoparticules pyroélectriques, de préférence de 10 % à 50%, plus préférentiellement 20% à 40%, et plus préférentiellement encore environ 30%, lesdits pourcentages étant des pourcentages en volume par rapport au volume total de la suspension.

12. Suspension colloïdale selon la revendication 11, **caractérisée en ce que** les nanoparticules ont une taille comprise entre 50 et 500 nm.

13. Utilisation du dispositif selon l'une quelconque des revendications 6 à 10, pour améliorer le rendement électrique des machines thermiques industrielles, permettre le développement des énergies renouvelables thermiques et pour récupérer l'énergie d'échappement des moteurs thermiques.

## Patentansprüche

1. Verfahren zur Umwandlung von thermischer Energie in elektrische Energie, das einen Schritt aufweist, der darin besteht, eine kolloidale Suspension aus pyroelektrischen Nanopartikeln mindestens einen Olsen-Zyklus durchlaufen zu lassen.

2. Verfahren nach Anspruch 1, **dadurch gekennzeichnet, dass** die Temperaturen T1 und T2 der zwei Isothermen des Olsen-Zyklus so gewählt sind, dass T1 und T2 in der Nähe von Tc sind.

3. Verfahren nach Anspruch 1, **dadurch gekennzeichnet, dass** die Potentiale V1 und V2 der zwei Isopotentiale des Olsen-Zyklus so gewählt sind, dass V1 kleiner als V2 ist, vorzugsweise V2 einen Wert hat, der kleiner ist als die Durchschlagsspannung (Vc) des verwendeten pyroelektrischen Materials.

4. Verfahren nach einem der Ansprüche 1 bis 3, mit den folgenden Schritten:
a) Halten einer Potentialdifferenz V2-V0 unter gleichzeitigem Heizen der Suspension bis zu einer Temperatur T2;
b) Verringern der Potentialdifferenz bis zu V1-V0 unter gleichzeitigem Halten der Suspension bei der Temperatur T2;
c) Halten der Potentialdifferenz V1-V0 unter gleichzeitigem Kühlen der Suspension bis zu einer Temperatur T1;
d) Erhöhen der Potentialdifferenz bis zu V2-V0 unter gleichzeitigem Halten der Suspension bei der Temperatur T1;
wobei die Temperatur T1 kleiner ist als die Temperatur T2 und die Potentialdifferenz V1-V0 kleiner ist als die Potentialdifferenz V2-V0.

5. Verfahren nach einem der Ansprüche 1 bis 4, mit den folgenden Schritten:
a) Halten der Potentialdifferenz V2-V0 unter gleichzeitigem Heizen der Suspension bis zu einer Temperatur T2;
b) Anlegen einer konstanten Potentialdifferenz an die bei der Temperatur T2 gehaltene Suspension, wobei die konstante Potentialdifferenz gleich ist derjenigen des vorausgehenden Schritts erniedrigt um einen Wert i;
b') Wiederholen des Schritts b) bis die Potentialdifferenz V1-V0 erreicht ist;
c) Halten der Potentialdifferenz V1-V0 unter gleichzeitigem Kühlen der Suspension bis zu einer Temperatur T1;
d) Anlegen einer konstanten Potentialdifferenz an die bei der Temperatur T1 gehaltene Suspension, wobei die konstante Potentialdifferenz gleich ist derjenigen des vorausgehenden Schritts erhöht um einen Wert i;
d') Wiederholen des Schritts d) bis die Potentialdifferenz V2-V0 erreicht ist;
wobei i ein Potentialintervall ist, das ungefähr gleich (V2-V1)/n ist, mit n gleich der Anzahl von Wiederholungen der obigen Schritte b und d.

6. Vorrichtung zur Umwandlung von thermischer Energie in elektrische Energie gemäß dem Verfahren nach einem der Ansprüche 1 bis 3, mit:
- Mittel zum Zirkulieren der Suspension;
- Mittel zum Übertragen von Wärme, die eine Änderung der Temperatur der Suspension erlauben;
- Mittel zum Anlegen eines variablen Potentials an die Suspension;
- Mittel zum Gewinnen der erzeugten elektrischen Energie.

7. Vorrichtung nach Anspruch 6, **dadurch gekennzeichnet, dass** die Mittel zum Zirkulieren der Suspension eine elektromagnetische Pumpe aufweisen.

8. Vorrichtung nach Anspruch 6 oder 7, **dadurch gekennzeichnet, dass** die Mittel zum Übertragen von Wärme mindestens zwei Wärmetauscher aufweisen.

9. Vorrichtung nach einem der Ansprüche 6 bis 8, die mehrere Paare Wärmetauscher aufweist, wobei jeder Wärmetauscher aus zwei ineinander verschlungenen Kreisläufen besteht, wobei der erste die Zirkulation eines warmen oder kalten Wärmeträgerfluides erlaubt, das im Austausch steht mit einer warmen oder kalten Quelle, und der zweite die Zirkulation der kolloidalen Suspension erlaubt, wobei an diesem zweiten Kreislauf leitfähige Platten angeordnet sind, die ein Anlegen eines Potentials erlauben, wobei jeder kalte Tauscher mit einem warmen Tauscher kombiniert ist, so dass im Betrieb die Suspension von einem warmen Tauscher zu einem kalten Tauscher und umgekehrt strömen kann.

10. Vorrichtung nach einem der Ansprüche 6 bis 9, **dadurch gekennzeichnet, dass** die Einrichtungen zum Gewinnen der elektrischen Energie einen Wechselrichter aufweisen, der die erzeugte Energie in einen Gleichstrom oder in einen Wechselstrom umwandeln kann.

11. Kolloidale Suspension aus pyroelektrischen Nanopartikeln, die zwischen 1% und 60% pyrolektrische Nanopartikel enthält, bevorzugt 10% bis 50%, weiter bevorzugt 20% bis 40% und noch weiter bevorzugt ungefähr 30%, wobei die Prozentangaben prozentuale Volumenanteile bezogen auf das Gesamtvolumen der Suspension sind.

12. Kolloidale Suspension nach Anspruch 11, **dadurch gekennzeichnet, dass** die Nanopartikel eine Größe zwischen 50 und 500 nm haben.

13. Verwendung der Vorrichtung nach einem der Ansprüche 6 bis 10, um den elektrischen Ertrag industrieller Wärmekraftmaschinen zu verbessern, die Entwicklung thermischer erneuerbarer Energien zu erlauben und die Abgasenergie von Verbrennungsmotoren zu gewinnen.

## Claims

1. A method for conversion of thermal energy into electrical energy comprising a step consisting in making a colloidal suspension of pyroelectric nanoparticles undergo at least one Olsen cycle.

2. The method as claimed in claim 1, **characterized in that** the temperatures T1 and T2 of the two isotherms of the Olsen cycle are chosen such that T1 and T2 are in the neighborhood of Tc.

3. The method as claimed in claim 1, **characterized in that** the potentials V1 and V2 of the two isopotentials of the Olsen cycle are chosen such that V1 is less than V2, and that preferably V2 has a value below the breakdown voltage (Vc) of the pyroelectric material used.

4. The method as claimed in any one of claims 1 to 3, comprising the following steps:
a) Maintain a potential difference V2-V0 while heating the suspension up to a temperature T2;
b) Decrease the potential difference down to V1-V0, while maintaining the suspension at the temperature T2;
c) Maintain the potential difference V1-V0, while cooling the suspension down to a temperature T1;
d) Increase the potential difference up to V2-V0, while maintaining the suspension at a temperature T1;
where the temperature T1 is lower than the temperature T2 and the potential difference V1-V0 is lower than the potential difference V2-V0.

5. The method as claimed in any one of claims 1 to 4, comprising the following steps:
a) Maintain the potential difference V2-V0, while heating the suspension up to a temperature T2;
b) Apply to the suspension maintained at the temperature T2 a constant potential difference equal to that of the preceding step decreased by a value i;
b') Repeat the step b) until the potential difference V1-V0 is reached;
c) Maintain the potential difference V1-V0 while cooling the suspension down to a temperature T1;
d) Apply to the suspension maintained at a temperature T1 a constant potential difference equal to that of the preceding step augmented by a value i;
d') Repeat the step d) until the potential difference V2-V0 is reached;
i being an interval of potential approximately equal to (V2-V1)/n, n being the number of repetitions of the steps b and d hereinabove.

6. A device for conversion of thermal energy into electrical energy according to the method of any one of claims 1 to 3 comprising:
- means for driving the circulation of said suspension;
- means for heat transfer allowing the temperature of said suspension to be varied;
- means for applying a variable potential to said suspension;
- means for recovery of the electrical energy generated.

7. The device as claimed in claim 6, **characterized in that** the means for driving the circulation of said suspension comprise an electromagnetic pump.

8. The device as claimed in either of claims 6 and 7, **characterized in that** the heat transfer means comprise at least two heat exchangers.

9. The device as claimed in any one of claims 6 to 8, comprising several pairs of heat exchangers, each heat exchanger being composed of two interlaced circuits, the first allowing the circulation of a hot or cold heat-carrying fluid, exchanging heat respectively with the hot or cold source, the second allowing the circulation of the colloidal suspension, and on this second circuit are disposed conducting plates allowing a potential to be applied, each cold exchanger being associated with a hot exchanger in such a manner that, in operation, the suspension can pass from a hot exchanger to a cold exchanger and vice versa.

10. The device as claimed in any one of claims 6 to 9, **characterized in that** the means for recovery of the electrical energy comprise an inverter capable of converting the energy generated into a DC current or into an AC current.

11. A colloidal suspension of pyroelectric nanoparticles comprising between 1% and 60% of pyroelectric nanoparticles, preferably from 10 % to 50%, more preferably from 20% to 40%, and most preferably around 30%, said percentages being percentages by volume with respect to the total volume of the suspension.

12. The colloidal suspension as claimed in claim 11, **characterized in that** the nanoparticles have a size in the range between 50 and 500 nm.

13. Use of the device as claimed in any one of claims 6 to 10 for improving the electrical efficiency of industrial thermal machines, for enabling the development of thermal renewable energies and for recovering the exhaust energy from thermal engines.
